# FASCICULE DE BREVET EUROPEEN

(11) **EP 1 672 699 B1**
(45) Date de publication et mention de la délivrance du brevet: **16.07.2008**
(21) Numéro de dépôt: 05112231.5
(22) Date de dépôt: 15.12.2005
(51) Int. Cl.: H01L 29/747

(54) **Commutateur bidirectionnel à commande en tension**
Spannungsgesteuerter Zweirichtungsschalter
Voltage controlled bidirectional switch

(30) Priorité: 15.12.2004 FR 0452991
(43) Date de publication de la demande: 21.06.2006
(73) Titulaire: ST MICROELECTRONICS S.A., 92120 Montrouge (FR)
(72) Inventeur: Menard, Samuel, 37000, Tours (FR)
(74) Mandataire: de Beaumont, Michel

(56) Documents cités:
- US-A- 5 608 235
- US-A- 6 034 381
- PATENT ABSTRACTS OF JAPAN vol. 013, no. 051 (E-712), 6 février 1989 (1989-02-06) -& JP 63 244881 A (TOSHIBA CORP; others: 01), 12 octobre 1988 (1988-10-12)
- SANCHEZ J-L ET AL: "Realization of vertical P<+> walls through-wafer for bi-directional current and voltage power integrated devices" 2003 IEEE 15TH. INTERNATIONAL SYMPOSIUM ON POWER SEMICONDUCTOR DEVICESAND IC'S PROCEEDINGS. CAMBRIDGE, UIK, APRIL 14 - 17, 2003, INTERNATIONAL SYMPOSIUM ON POWER SEMICONDUCTOR DEVICES & IC'S, NEW YORK, NY : IEEE, US, 14 avril 2003 (2003-04-14), pages 195-198, XP010653757 ISBN: 0-7803-7876-8

## Description

### Domaine de l'invention

La présente invention concerne le domaine des commutateurs bidirectionnels, et plus particulièrement des commutateurs bidirectionnels réalisés sous forme de composants verticaux dans lesquels le signal appliqué à l'électrode de commande est appliqué en référence à la tension sur la face arrière du composant, qui est habituellement dans les composants verticaux uniformément métallisée.

### Exposé de l'art antérieur

Ce type de composant est décrit notamment dans le brevet américain 6 034 381 de Robert Pezzani, cédé à la demanderesse (B3073).

Les figures 1A, 1B, 1C ci-jointes reproduisent les figures 1A, 1B et 1C de ce brevet américain 6 034 381.

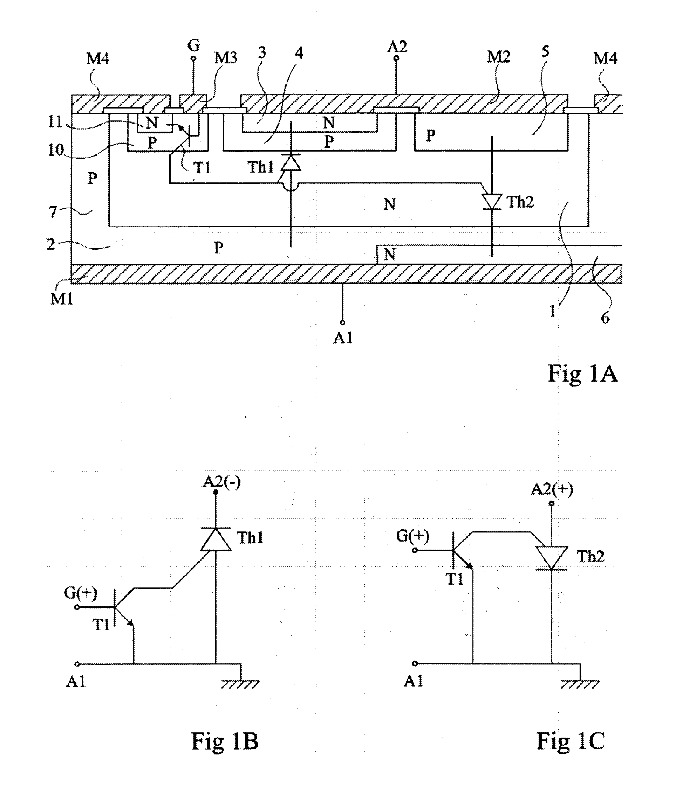

La structure de la figure 1A est formée à partir d'un substrat semiconducteur 1 de type N faiblement dopé. Ce commutateur bidirectionnel comprend deux thyristors verticaux en antiparallèle Th1 et Th2. L'anode du thyristor Th1 correspond à une couche 2 de type P formée du côté de la face arrière du substrat. Sa cathode correspond à une région 3 du deuxième type de conductivité formée du côté de la face avant dans un caisson 4 de type P. L'anode du thyristor Th2 correspond à un caisson 5 de type P formé du côté de la face avant et sa cathode correspond à une région 6 de type N formée du côté de la face arrière dans la couche 2. Ce commutateur bidirectionnel est du type dit à caisson, c'est-à-dire que sa périphérie est constituée d'un mur 7 de type P fortement dopé s'étendant depuis la face avant jusqu'à la couche de face arrière 2 de type P. La face arrière est revêtue d'une métallisation M1 correspondant à une première borne principale A1 du commutateur bidirectionnel et les faces supérieures des régions 3 et 5 sont revêtues d'une deuxième métallisation M2 correspondant à la deuxième borne principale A2 du commutateur bidirectionnel.

La structure de déclenchement de ce commutateur bidirectionnel comprend un caisson 10 de type P formé du côté de la face avant ou supérieure dans lequel est formée une région 11 de type N. La surface du caisson 10 est solidaire d'une métallisation M3 reliée à une borne de gâchette G du commutateur bidirectionnel et la surface de la région 11 est reliée par une métallisation M4 à la surface supérieure du mur périphérique 7 fortement dopé de type P.

On a également représenté sur la figure 1A les symboles de divers composants résultant de la structure représentée. Ainsi, on a représenté les thyristors Th1 et Th2 susmentionnés et un transistor T1 dont la base correspond au caisson 10 et à la métallisation de gâchette G, dont l'émetteur correspond à la région 11 et à la métallisation M4 (c'est-à-dire que cet émetteur est relié par le caisson 7 à la première électrode principale A1 de face arrière ou inférieure du commutateur bidirectionnel), et dont le collecteur correspond au substrat 1, c'est-à-dire aux régions de gâchette d'anode des thyristors Th1 et Th2.

Habituellement, un tel commutateur bidirectionnel est monté de sorte que sa face arrière, généralement reliée à un radiateur, est connectée à la masse et que sa face avant est reliée à une tension alternativement positive et négative par rapport à la masse.

Le brevet de R. Pezzani expose que l'on obtient une structure de commutateur bidirectionnel dans laquelle l'électrode de commande G est disposée sur la face avant et dans laquelle le commutateur bidirectionnel est déclenché par application sur l'électrode de commande G d'un signal de polarité positive par rapport au potentiel de l'électrode de face arrière A1.

Des structures de type de celles décrites en figure 1 ont été fabriquées par la demanderesse qui a d'ailleurs déposé plusieurs brevets visant des perfectionnements de cette structure.

Toutefois, cette structure présente l'inconvénient selon lequel, comme dans le cas d'un triac classique, la commande se fait par une injection de courant. Or il est toujours plus facile de commander un interrupteur par une source de tension que par une source de courant.

Ainsi, un objet de la présente invention est de prévoir un commutateur bidirectionnel dans lequel la commande est référencée au potentiel de la face arrière et qui soit commandé en tension.

### Résumé de l'invention

Pour atteindre cet objet, la présente invention prévoit un commutateur monolithique bidirectionnel vertical à commande en tension, référencée par rapport à la face arrière du commutateur, formé à partir d'un substrat semiconducteur faiblement dopé de type N, dans lequel la structure de commande comprend, du côté de la face avant, un premier caisson de type P dans lequel est formée une région de type N, et un deuxième caisson de type P dans lequel est formé un transistor MOS, le premier caisson de type P et la grille du transistor MOS étant reliés à une borne de commande, ladite région de type N étant connectée à une borne principale du transistor MOS, et la deuxième borne principale du transistor MOS étant connectée au potentiel de face arrière du commutateur.

Selon un mode de réalisation de la présente invention, la structure monolithique est entourée d'un mur fortement dopé de type P en contact avec une métallisation de face arrière, la connexion entre la deuxième borne principale du transistor MOS et le potentiel de la face arrière étant assurée par une métallisation reliant cette deuxième borne principale à la face supérieure dudit mur.

Selon un mode de réalisation de la présente invention, la liaison entre la borne de commande et, d'une part, le premier caisson de type P et, d'autre part, la grille est assurée par l'intermédiaire de résistances respectives, la première résistance entre la borne de commande et un contact sur le premier caisson étant élevée et la seconde résistance entre la borne de commande et la grille étant faible.

Selon un mode de réalisation de la présente invention, la première résistance est de l'ordre d'une centaine de kiloohms et la seconde résistance est inférieure à 100 ohms.

Selon un mode de réalisation de la présente invention, le commutateur comprend, du côté de la face arrière, entre la structure semiconductrice et la métallisation de façon arrière, une couche isolante s'étendant au moins sous la zone de commande et pas sous la zone de puissance.

### Brève description des dessins

Ces objet, caractéristiques et avantages, ainsi que d'autres de la présente invention seront exposés en détail dans la description suivante de modes de réalisation particuliers faite à titre non limitatif en relation avec les figures jointes parmi lesquelles :
les figures 1A, 1B et 1C sont respectivement une vue en coupe schématique et des schémas équivalents d'une structure de commutateur bidirectionnel à commande en courant selon l'art antérieur ;
les figures 2A et 2B sont respectivement une vue en coupe schématique et un schéma équivalent d'une structure de commutateur bidirectionnel à commande en tension selon la présente invention ;
les figures 3A et 3B sont respectivement une vue de dessus et une vue de dessous d'un premier mode de réalisation d'un commutateur bidirectionnel selon la présente invention ; et
les figures 4A et 4B sont respectivement une vue de dessus et une vue de dessous d'un deuxième mode de réalisation d'un commutateur bidirectionnel selon la présente invention.

### Description détaillée

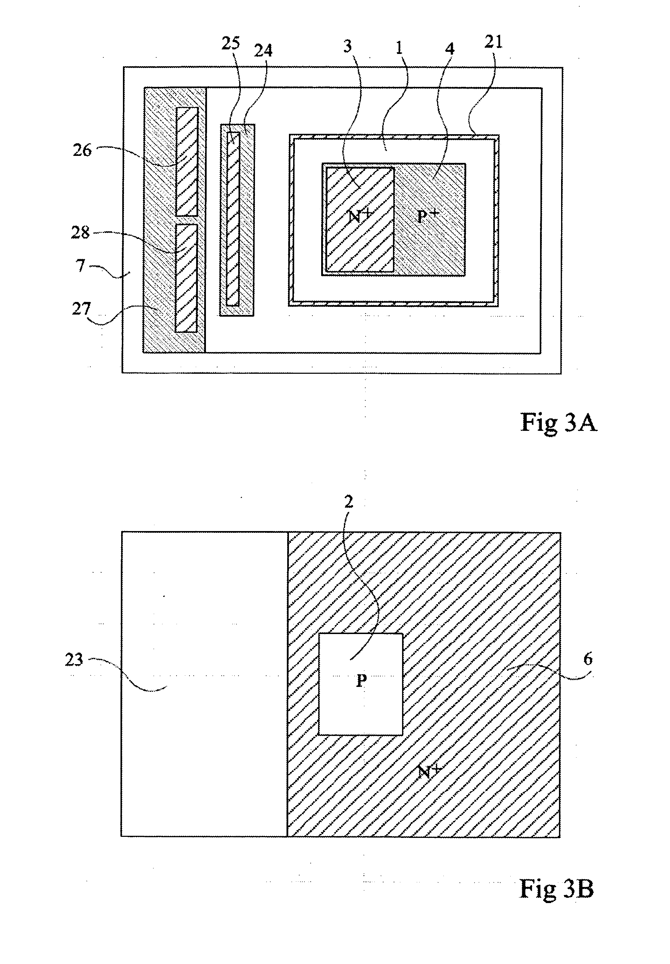

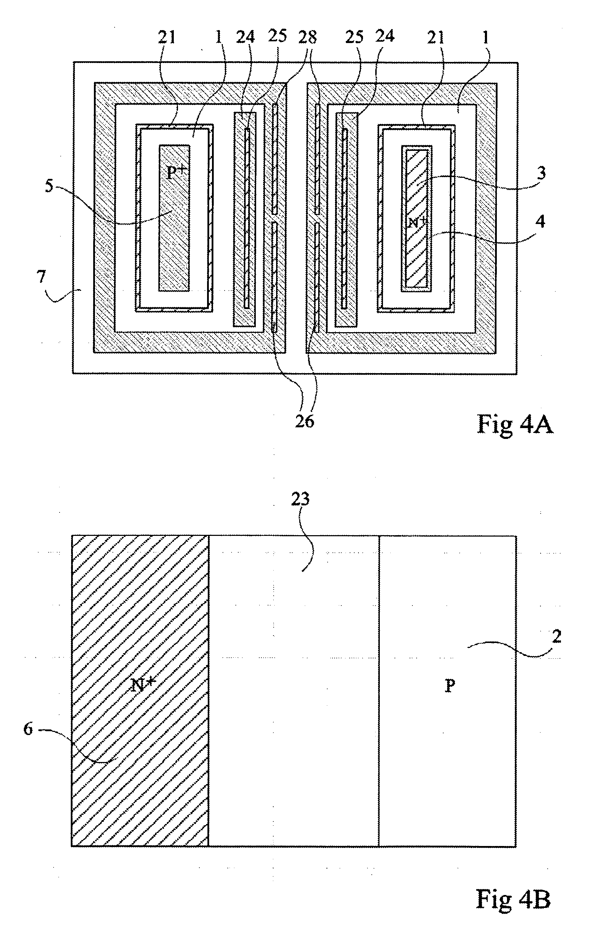

Par souci de clarté, de mêmes éléments ont été désignés par de mêmes références aux différentes figures. De plus, comme cela est habituel dans le domaine de la représentation des composants semiconducteurs, les diverses vues en coupe sont extrêmement schématiques et ne sont pas à l'échelle. Pour un exemple de réalisation pratique, on pourra se référer aux vues de dessus et de dessous des figures 3 et 4.

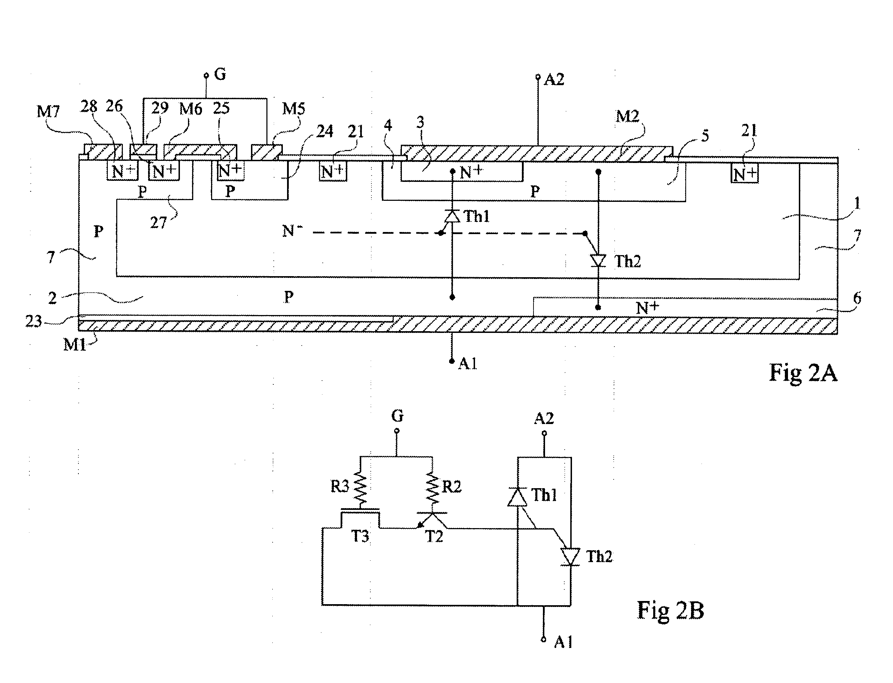

La figure 2A est une vue en coupe schématique d'un mode de réalisation d'un commutateur bidirectionnel à commande en tension selon la présente invention.

Dans cette figure, des éléments similaires à ceux déjà décrits en relation avec la figure 1A portent les mêmes références. Ainsi, on retrouve en figure 2A, entre les bornes A1 et A2, un thyristor Th1 dont l'anode se trouve du côté de la métallisation inférieure M1 et qui comprend des régions ou couches 2-1-4-3 et un thyristor Th2 dont l'anode se trouve du côté de la face supérieure et qui comprend les portions de région et de couche 5-1-2-6.

En figure 2A, on a représenté les caissons 4 et 5 du thyristor Th1 et du thyristor Th2 comme des parties d'un même caisson. Toutefois, on pourrait avoir la même disposition qu'en figure 1A (réalisation en deux parties des caissons 4 et 5). En outre, on a représenté un anneau d'arrêt de canal 21 optionnel qui entoure l'ensemble du caisson 4-5.

De plus, il apparaît du côté de la face inférieure entre la métallisation M1 et la couche 2 de type P une couche isolante 23 qui se trouve sensiblement sur toute la face inférieure en dehors de la partie en regard du caisson 4. La disposition de cette couche se comprendra mieux en se référant aux vues de dessous des figures 3B et 4B. La fonction de cette couche isolante est de favoriser le déclenchement du commutateur en amenant les porteurs de charge produits dans la zone de commande à se propager vers la zone de puissance (thyristors Th1 et Th2) après qu'un signal de commande est appliqué. Une couche de type N+ aurait une fonction similaire.

La zone de commande comprend un premier caisson de type P 24 dans lequel est formée une région de type N 25. Ce caisson et cette région sont désignés par des références différentes de celles du caisson 10 et de la région 11 de la figure 1A, car, comme on le verra ci-après, le niveau de dopage et la profondeur du caisson 24 sont de préférence distincts de ce qui a été décrit précédemment dans l'art antérieur. Une métallisation M5 est en contact avec le caisson 24. La région de type N 25 est connectée par une métallisation M6 à une région de source 28 de type N⁺ d'un transistor MOS T3 formé dans un caisson de type P 27. Le transistor MOS T3 comprend une région de drain 26 de type N⁺ et sa zone de formation de canal de type P est surmontée d'une grille conductrice 29. Une métallisation M7 relie la région 28 au mur périphérique 7 fortement dopé de type P pour établir un contact avec la région 2 de type P de face arrière et la métallisation M1. Une borne de gâchette G est solidaire de la métallisation M5 et de la grille 29 du transistor MOS, de préférence par l'intermédiaire de résistances qui sont représentées dans le schéma équivalent de la figure 2B et qui peuvent être réalisées sous forme intégré bien qu'elles ne soient pas représentées en figure 2A.

Le caisson 27 peut, comme cela est représenté, être contigu au mur périphérique 7 ou bien peut être un caisson séparé, la liaison entre le drain 28 et la surface supérieure de ce mur étant assurée par la métallisation M7. De plus, le transistor MOS T3 a été représenté de façon extrêmement schématique. Toute variante d'un tel transistor pourra être utilisée. Notamment, le transistor MOS pourra de façon classique avoir une structure multicellulaire en utilisant par exemple une structure à deux métallisations pour établir les contacts.

Un schéma équivalent de ce commutateur bidirectionnel est illustré en figure 2B. On a représenté un transistor NPN T2 ayant la région 25 comme émetteur, la région 24 comme base et le substrat 1 comme collecteur. La liaison entre la borne de commande G et la base de ce transistor est assurée par l'intermédiaire d'une résistance R2 et la liaison entre la borne de commande G et la grille du transistor MOS T3 est assurée par l'intermédiaire d'une résistance R3. A titre d'exemple, la résistance R2 peut avoir une valeur de l'ordre d'une centaine de kiloohms et la résistance R3 une valeur de l'ordre d'une centaine d'ohms.

Le fonctionnement de ce dispositif est le suivant.

Quelle que soit la polarité de la borne A2 par rapport à la borne A1, le circuit est commandé par l'application d'une tension positive sur la borne G.

Durant une alternance positive, c'est-à-dire quand la borne A2 est positive par rapport à la borne A1, et quand un signal positif est appliqué à la borne G, le transistor MOS T3 devient passant et un courant circule de la métallisation M5 à la métallisation M6 dans la diode 24-25 et dans le transistor MOS vers la borne A1. La mise en conduction de cette diode 24-25 entraîne l'injection d'électrons par la région N⁺ 25. Une partie de ces électrons, limitée en raison de la forte valeur de la résistance R2, repart vers la borne G. Une autre partie de ces électrons atteint le substrat 1 et est attirée par l'anode constituée de la couche 4-5 reliée par la métallisation M2 à la borne A2. Il en résulte une injection de trous par la région 4-5 vers la jonction entre le substrat 1 et la couche P inférieure 2. En raison de la présence de la couche isolante 23, cette injection se produit essentiellement dans la zone de puissance et il en résulte la mise en conduction du thyristor Th2.

Un fonctionnement symétrique survient quand la borne A2 est négative par rapport à la borne A1 (alternance négative). Alors, l'application d'une tension positive sur la borne G rend passant le transistor MOS T3, un courant circule dans la diode 24-25. Il en résulte une injection d'électrons dans le substrat. Cette fois-ci, ces électrons se dirigent vers la couche 2 qui est reliée à la borne positive A1 et cette couche 2 injecte des trous dans le substrat qui tendent à débloquer la jonction bloquante du thyristor Th1 entre le substrat 1 et le caisson 4 de type P.

Selon un avantage de la présente invention, quand aucun signal n'est appliqué sur la borne G, le transistor MOS T3 est bloqué et ne peut laisser passer aucun courant. Ainsi, en l'absence de signal de grille, le transistor NPN T2 en série avec le transistor MOS T3 a son émetteur en l'air et ne peut en aucun cas devenir passant, même si des charges sont injectées dans le substrat par divers effets parasites, par exemple par l'application d'une forte variation de tension en fonction du temps (dV/dt) entre les bornes A2 et A1. Il en résulte, d'une part, que l'on peut choisir un transistor T2 à gain très élevé, d'autre part, que l'on peut choisir un ensemble de deux thyristors particulièrement sensibles. Un transistor à gain élevé peut être obtenu en optimisant le caisson 24 pour que notamment, l'épaisseur de la base (24) entre émetteur et collecteur soit faible. Des thyristors sensibles peuvent par exemple résulter d'une topologie optimisée et d'une faible densité de courts-circuits d'émetteur. Il en résulte que le transistor T2 peut être déclenché par un très petit courant, et que l'on peut placer une résistance R2 de valeur élevée en série sur sa base. Ainsi, lors de la commande et du fonctionnement ultérieur, un courant extrêmement faible est injecté dans la base du transistor T2. Il en résulte que l'on a en pratique une commande en tension et non plus une commande en courant comme dans l'art antérieur.

Deux exemples de réalisation plus détaillés de la présente invention sont illustrés respectivement dans les vues de dessus et de dessous des figures 3A et 3B et dans les vues de dessus et de dessous des figures 4A et 4B. Dans ces vues de dessus et de dessous, les métallisations ont été supprimées, mais on comprendra comment les disposer à partir de la vue en coupe schématique de la figure 2A et du schéma de circuit de la figure 2B.

Dans le mode de réalisation des figures 3A et 3B, comme dans la vue en coupe schématique de la figure 2A, les caissons 4 et 5 de type P constituent un seul et même caisson. On comprendra que la zone de canal du transistor MOS T3 est disposée dans les parties en regard des régions 26, 28 de type N⁺.

Dans l'exemple des figures 4A et 4B, les deux thyristors Th1 et Th2 sont séparés et disposés de part et d'autre de la structure. Les caissons 4 et 5 sont donc distincts et le mur d'isolement 7 comprend une partie médiane séparant les deux structures. Deux zones de commande sont disposées symétriquement par rapport à la partie médiane du mur d'isolement, chacune ayant sensiblement la même structure que ce qui a été représenté et décrit précédemment.

Bien entendu, les figures 3 et 4 ne représentent que certains exemples particuliers de réalisation de la présente invention. De nombreuses autres réalisations pratiques apparaîtront à l'homme de métier quant à la topologie des diverses couches, l'aspect essentiel de l'invention résidant dans la réalisation sous forme monolithique d'un circuit correspondant à ce qui est illustré en figure 2B.

## Revendications

1. Commutateur monolithique bidirectionnel vertical à commande en tension, référencée par rapport à la face arrière du commutateur, formé à partir d'un substrat semiconducteur faiblement dopé de type N, **caractérisé en ce que** la structure de commande comprend, du côté de la face avant, un premier caisson de type P (24) dans lequel est formée une région de type N (25), et un deuxième caisson de type P (27) dans lequel est formé un transistor MOS (T3), le premier caisson de type P (24) et la grille (29) du transistor MOS étant reliés à une borne de commande (G), ladite région de type N (25) étant connectée à une borne principale (26) du transistor MOS, et la deuxième borne principale (28) du transistor MOS étant connectée au potentiel de face arrière du commutateur.

2. Commutateur selon la revendication 1, dans lequel la structure monolithique est entourée d'un mur (7) fortement dopé de type P en contact avec une métallisation de face arrière (M1), la connexion entre la deuxième borne principale du transistor MOS et le potentiel de la face arrière étant assurée par une métallisation (M7) reliant cette deuxième borne principale à la face supérieure dudit mur.

3. Commutateur selon la revendication 1, dans lequel la liaison entre la borne de commande (G) et, d'une part, le premier caisson de type P et, d'autre part, la grille (29) est assurée par l'intermédiaire de résistances respectives, la première résistance (R2) entre la borne de commande et un contact (M5) sur le premier caisson étant élevée et la seconde résistance (R3) entre la borne de commande et la grille étant faible.

4. Commutateur selon la revendication 3, dans lequel la première résistance est de l'ordre d'une centaine de kilo-ohms et la seconde résistance est inférieure à 100 ohms.

5. Commutateur selon la revendication 1, comprenant, du côté de la face arrière, entre la structure semiconductrice et la métallisation de façon arrière (M1), une couche isolante (23) s'étendant au moins sous la zone de commande et pas sous la zone de puissance.

## Claims

1. A voltage-controlled vertical bi-directional monolithic switch, referenced with respect to the rear surface of the switch, formed from a lightly-doped N-type semiconductor substrate, **characterized in that** the control structure comprises, on the front surface side, a first P-type well (24) in which is formed an N-type region (25), and a second P-type well (27) in which is formed a MOS transistor (T3), the first P-type well (24) and the gate (29) of the MOS transistor being connected to a control terminal (G), said N-type region (25) being connected to a main terminal (26) of the MOS transistor, and the second main terminal (28) of the MOS transistor being connected to the rear surface voltage of the switch.

2. The switch of claim 1, wherein the monolithic structure is surrounded with a heavily-doped P-type wall (7) in contact with a rear surface metallization (M1), the connection between the second main terminal of the MOS transistor and the voltage of the rear surface being ensured by a metallization (M7) connecting this second main terminal to the upper surface of said wall.

3. The switch of claim 1, wherein the connection between the control terminal (G) and, on the one hand, the first P-type well and, on the other hand, the gate (29) is ensured via respective resistors, the first resistance (R2) between the control terminal and a contact (M5) on the first well being high and the second resistance (R3) between the control terminal and the gate being low.

4. The switch of claim 3, wherein the first resistance is on the order of some hundred kilo-ohms and the second resistance is smaller than 100 ohms.

5. The switch of claim 1, comprising, on the rear surface side, between the semiconductor structure and the rear surface metallization (M1), an insulating layer (23) extending at least under the control area and not under the power area.

## Patentansprüche

1. Spannungsgesteuerter vertikaler bidirektionaler monolithischer Schalter, der von der Rückseite des Schalters her aus einem leicht dotierten N-Typ-Halbleitersubstrat ausgebildet ist, **dadurch gekennzeichnet, dass** die Steuerstruktur auf der Vorderseite eine erste P-Typ-Wanne (24) aufweist, in der ein N-Typ-Bereich (25) ausgebildet ist, und eine zweite P-Typ-Wanne (27), in der ein MOS-Transistor (T3) ausgebildet ist, wobei die erste P-Typ-Wanne (24) und das Gate (29) des MOS-Transistors mit einem Steueranschluss (G) verbunden sind, wobei der N-Typ-Bereich (25) mit einem Hauptanschluss (26) des MOS-Transistors verbunden ist, und der zweite Hauptanschluss (28) des MOS-Transistors mit der Rückseitenspannung des Schalters verbunden ist.

2. Schalter nach Anspruch 1, wobei die monolithische Struktur mit einer stark dotierten P-Typ-Wand (7) umgeben ist, die in Kontakt mit einer Rückoberflächenmetalliersierung (M1) steht, wobei die Verbindung zwischen dem zweiten Hauptanschluss des MOS-Transistors und der Spannung an der Rückseite durch eine Metallisierung (M7) sichergestellt wird, die diesen zweiten Hauptanschluss mit der Oberseite der Wand verbindet.

3. Schalter nach Anspruch 1, wobei die Verbindung zwischen dem Steueranschluss (G) und der ersten P-Typ-Wanne einerseits und dem Gate (29) andererseits über jeweilige Widerstände sichergestellt wird, wobei der erste Widerstand (R2) zwischen dem Steueranschluss und einem Kontakt (M5) an der ersten Wanne hoch ist und der zweite Widerstand (R3) zwischen dem Steueranschluss und dem Gate niedrig ist.

4. Schalter nach Anspruch 3, wobei der erste Widerstand in der Größenordnung von einigen 100 Kilo-Ohm liegt und der zweite Widerstand kleiner als 100 Ohm ist.

5. Schalter nach Anspruch 1, der auf der Rückoberflächenseite zwischen der Halbleiterstruktur und der Rückoberflächenmetallisierung (M1) eine Isolierschicht (23) aufweist, die sich wenigstens unterhalb des Steuerbereichs und nicht unterhalb des Leistungsbereichs erstreckt.
